# EUROPEAN PATENT SPECIFICATION

(11) **EP 0 572 704 B1**
(45) Date of publication and mention of the grant of the patent: **19.04.2000**
(21) Application number: 92109549.3
(22) Date of filing: 05.06.1992
(51) Int. Cl.: H01L 21/3105, H01L 21/316

(54) **Method for manufacturing a semiconductor device including method of reforming an insulating film formed by low temperature CVD**
Verfahren zur Herstellung einer Halbleiteranordnung mittels eines Verfahren zur Reformierung einer Isolationsschicht die bei niederiger Temperatur durch CVD hergestellt ist
Procédé de fabrication d'un dispositif semi-conducteur comportant une méthode de réforme d'une couche isolante obtenue par CVD à basse température

(43) Date of publication of application: 08.12.1993
(73) Proprietor: SEMICONDUCTOR PROCESS LABORATORY CO., LTD., Minato-ku, Tokyo 108 (JP); ALCAN- TECH CO., INC., Tokyo (JP); CANON SALES CO., INC., Minato-ku, Tokyo 108 (JP)
(72) Inventor: Kazuo, Maeda c7o Semicond. Process Lab. Co.Ltd, Tokyo (JP); Noburo,Tokumasu c/o Semicond. Process Lab.Co.Ltd, Tokyo (JP); Yuko, Nishimoto, Minato-ku, Tokyo (JP)
(74) Representative: Schwabe - Sandmair - Marx

(56) References cited:
- DE-A- 2 324 719
- FR-A- 2 068 673
- ELECTRONICS LETTERS. vol. 26, no. 11, 24 May 1990, ENAGE GB pages 733 - 734 , XP000108687 K. AITE ET AL. 'NOVEL LOW TEMPERATURE RF PLASMA ANNEALING USING NH3-N2 GAS MIXTURE'
- RCA REVIEW vol. 37, no. 1, March 1976, PRINCETON US pages 55 - 77 W.KERN 'DENSIFICATION OF VAPOR-DEPOSITED PHOSPHOSILICATE GLASS FILMS.'

## Description

### BACKGROUND OF THE INVENTION

### (1) Industrial Field of Utilization

The present invention relates to a method for manufacturing a semiconductor device, and more particularly to a method for manufacturing a semiconductor device including a method for reforming an insulating film formed by a low temperature CVD method.

### (2) Prior Art

There are a variety of methods for forming an insulating film by a Chemical Vapor Deposition (CVD) method, but a thermal CVD method and a plasma CVD method are mainly used in recent years. Now, still higher refinement and higher densification are demanded in a very Large Scale Integrated Circuit (VLSI) and in a DRAM in particular. Thus, it is undesirable to form an insulating film by the plasma CVD method because step coverage is inferior and impurities such as carbon (C) are contained in a formed insulating film. As a result, application of a thermal CVD method superior in step coverage, among others a thermal CVD method capable of forming a film at a low temperature so as to exert no thermal influence upon others attracts attention for forming a refined and highly densified DRAM, but further improvement of the film quality is desired.

There have been those methods that are conducted under the following conditions as a thermal CVD methods capable of forming a film at a low temperature:
① reaction gas is mixed gas of mono-silane (SiH₄)/oxygen (O₂), and temperature is from 350°C to 450°C,
② reaction gas is mixed gas of organic silane (TEOS)/ozone (O₃), and temperature is from 350°C to 450°C.
Since the forming temperature is low in both cases, it is possible to restrain thermal distortion, thus exerting small influence upon the circumference. Therefore, such CVD method is adopted in many cases to form a passivation film and the like on an Aℓ interconnection layer.

In case a design rule of a device is not over 1µm, however, the quality of an interlevel insulating film and the like exerts a big influence upon characteristics of a device, and following problems have been newly posed also on an interlevel insulating film formed by the thermal CVD method. Namely, such problems that are related to reliability due to:
① lowering of dielectric breakdown strength,
② increase of leakage current, and
③ corrosion of an Aℓ film and the like
are caused sometimes because of such reasons that:
① the density of a formed insulating film is low,
② moisture (H₂O) and a bond such as Si-OH are contained in a formed insulating film, and
③ a bond such as Si-H is contained. In order to solve such problems, it is required:

① to form a film at a highest possible temperature,
② to form a film while reducing a growth rate to the minimum,
③ to increase O₃ concentration to the maximum in a method using TEOS, and
④ to anneal the film at a highest possible temperature after film formation, but there are limits in respective cases. For example, it is not desirable to adjust the temperature to above 450°C from a viewpoint of diffusion of Aℓ into a Si substrate, generation of hillocks and the like in case of forming an interlevel insulating film for covering a lower Aℓ interconnection layer. Further, the growth rate cannot be reduced too low in order to secure mass productivity.

FR-A-2068673 discloses a method for manufacturing a semiconductor device comprising the steps of (a) forming an insulating film on a semiconductor body by a low temperature CVD-method (300 - 500 °C) and (b) reforming said layer by a plasma treatment of a heated semiconductor body in inert gas. Further this document shows the repeating of the deposition and the plasma treatment of the insulating layers.

RCA REVIEW VOL. 37, NO 1, March 1976, P. 55 - 77, discloses the densification of chemically vapor-deposited insulating glass films in hydrogen plasma with temperatures of 350°C to 450°C.

ELECTRONICS LETTERS VOL. 26, NO 11, 24 May 1990, P. 733-734, shows the plasma treatment of a SiO2 surface with a glow discharge of a NH3/N2 gas mixture at low temperatures (350 °C).

DE-A-2324719 finally discloses a method for reforming a dielectric anorganic film on a substrate with a reacting plasma gas in a low temperature environment, where oxygen is used as the reacting plasma gas.

### SUMMARY OF THE INVENTION

It is an object of the present invention which has been made in view of such conventional problems to provide a method for manufacturing a semiconductor device capable of improving a film quality of an insulating film formed by a thermal CVD method at a low temperature. The means thereof will be described hereunder.

This object is achieved by a method for manufacturing a semiconductor device comprising the steps of: contacting an insulating film (4), which is a SiO₂ film or a SiO₂ film doped with impurities such as PSG film, a BSG film or a BPSG film and which is formed by low temperature chemical vapor deposition on a device substrate (1), with a plasma while heating said insulating film (4), thereby densifying said film (4), characterized in that the plasma consists of ammonia gas.

In the present method of manufacturing a semiconductor device said contacting is conducted with said film at a temperature of 350 °C to 450 °C.

Preferably said insulating film is doped with impurities.

In the present method of manufacturing a semiconductor device said insulating film doped with impurities is one selected from the group consisting of a PSG film, a BSG film and a BPSG film.

Preferably said insulating film is formed on said substrate by repeating the manufacturing method two times or more.

The operation of the present invention will be described based on experiments performed by the present inventor. In the following description thicknesses are indicated in Angström (Å), wherein 1Å is equal to 0.1 nm.

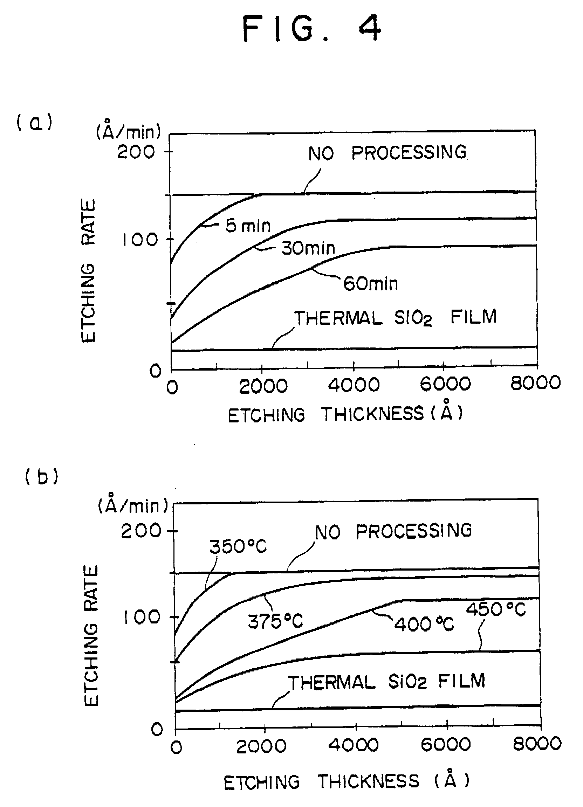

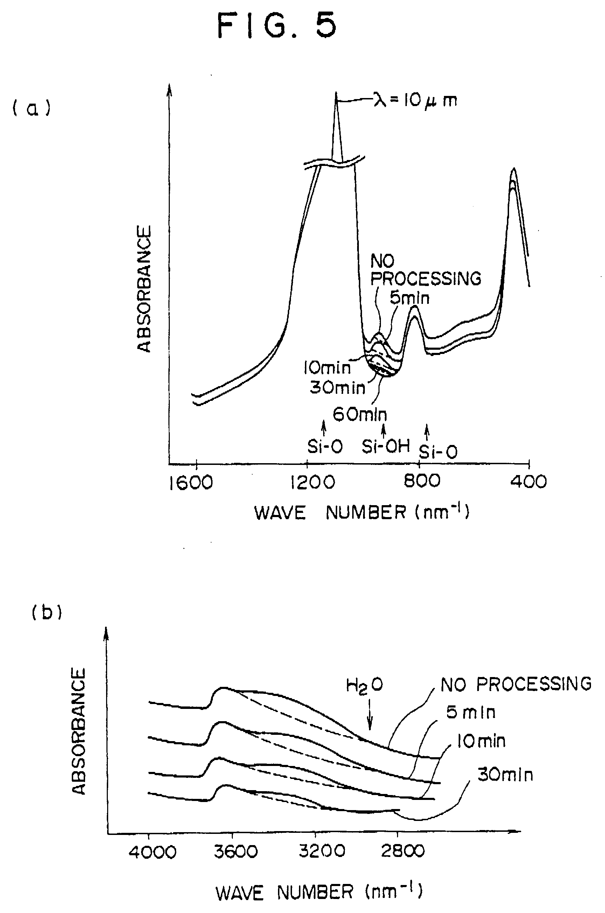

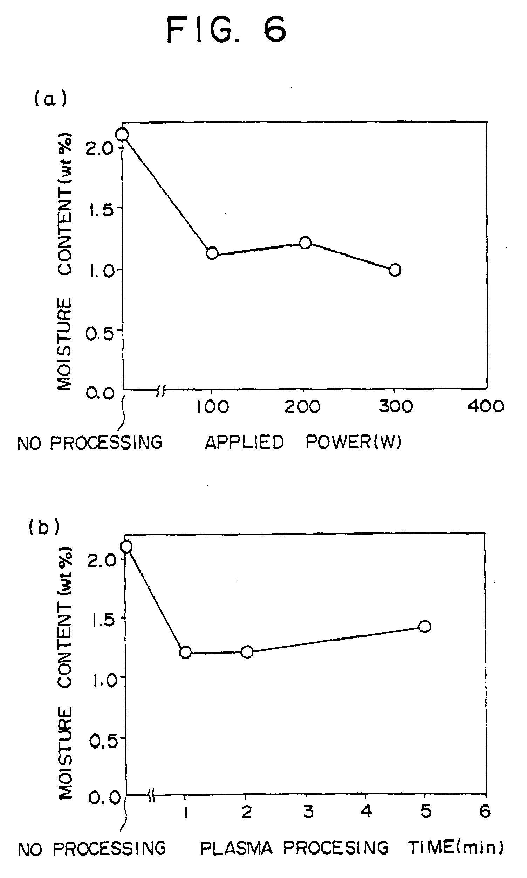

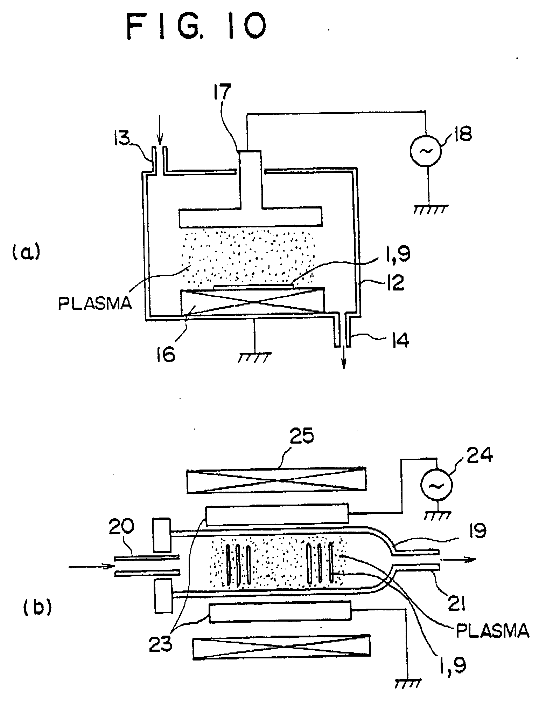

Figs. 4(a), (b) and Figs. 5(a), (b) show the results of comparative experiments of plasma processing performed by the present inventor using oxygen plasma gas. Further, Figs. 6(a), (b), Fig. 7(c), Figs. 8(a), (b) and Figs. 9(c), (d) show the results of experiments performed according to the invention by the present inventor using ammonia plasma gas. Further, Fig. 10(a) shows a structure of a plasma processing system used in experiments performed by the present inventor.

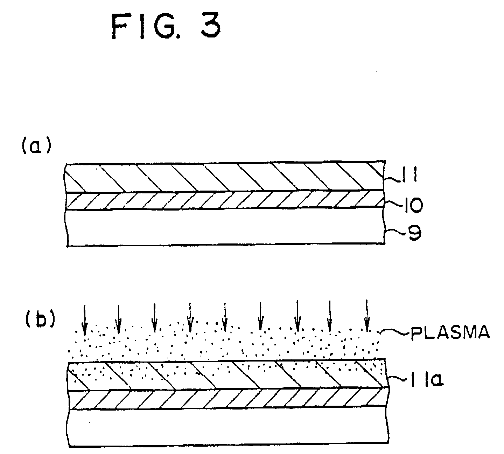

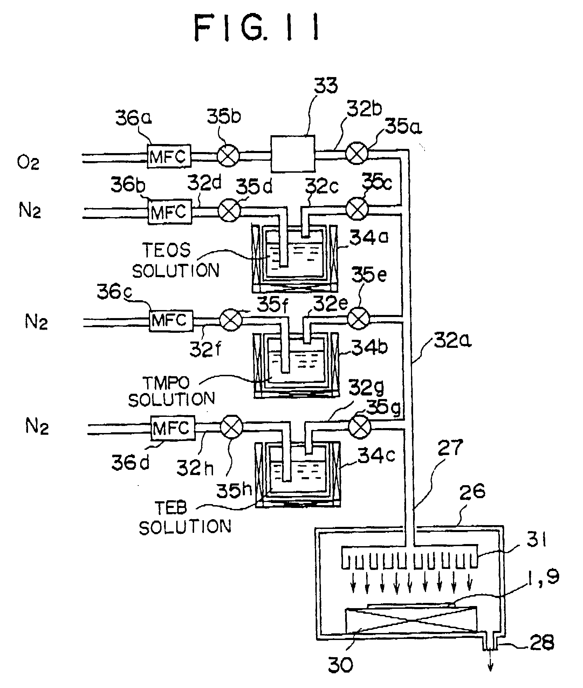

Samples used in the experiments were produced as shown in Figs. 3(a) and (b). Namely, a CVD SiO₂ film 11 having a film thickness of 6,000 to 8,000Å is formed on a SiO₂ film 10 formed by thermal oxidation on a Si substrate (wafer) 9 (Fig. 3(a)) by a CVD system as shown in Fig. 11 under such conditions that:
① reaction gas is mixed gas of organic silane (TEOS)/ozone (O₃) (O₃ concentration: 5% in O₂),
② wafer temperature is at 400°C, and
③ forming rate is at 800 to 1,000Å/min.

Then, after the wafer 9 is placed on a wafer placing table 16 in a chamber 12 of a plane parallel plate type plasma processing system such as shown in Fig. 10(a), the wafer is heated with a heater and the wafer temperature is maintained at a constant temperature. In succession, after introducing processing gas into the chamber 12 through a gas inlet port 13, an electric power having a frequency of 13.56 MHz is applied to this gas by means of an RF power supply 18 so as to activate the processing gas and to convert it into plasma, thus maintaining it for a predetermined period of time.

Here, various conditions were adopted as to applied electric power, plasma processing time and wafer temperature as shown hereunder.

### (1) When oxygen gas is used as the processing gas:

① plasma processing time: 5, 30, 60 minutes.
② wafer temperature: 350, 375, 400, 450°C.

### (2) When ammonia gas is used as the processing gas:

① applied electric power: 100, 200, 300W.
② plasma processing time: 1, 2, 5 minutes.
③ wafer temperature: 200, 300, 400°C.

Besides, it has also been found that a CVD SiO₂ film 11a is not etched by such plasma processing.

Next, following investigation was made on the CVD SiO₂ film 11a processed as described above. The type of investigation and the results of investigation are described while drawing a line between the case of oxygen gas and the case of ammonia gas.

### (1) In the case of oxygen gas (not according to the invention):

### (a) Type of investigation

① Investigation of denseness of a film by the etching rate using an HF solution (Figs. 4(a) and (b), and
② investigation of film composition by means of infrared absorption spectrum (Figs. 5(a) and (b)) were performed. Besides, similar investigation was also made on a CVD SiO₂ film applied with no plasma processing and a thermal oxide film formed by thermal oxidation for the purpose of comparison.

### (b) Results of investigation

Figs. 4(a) and (b) show the results of investigation on the denseness of a film by etching rate, in which Fig. 4(a) shows the result of investigating the change of the etching rate with respect to the etching thickness with plasma processing time as a parameter under the condition that the wafer temperature is maintained constant at 350°C, and Fig. 4(b) shows the result of investigating the change of the etching rate with respect to the etching thickness with the wafer temperature as a parameter under the condition that the plasma processing time is maintained constant at 5 minutes.

The results show that, as the plasma processing time gets longer or the wafer temperature gets higher, the etching rate is reduced, the influence thereof being exerted down to a deep location from the surface, and the etching rate gets closer to the etching rate of the thermal oxide film gradually, and the CVD SiO₂ film becomes denser.

Further, Figs. 5(a) and (b) show the result of investigating the film composition by infrared absorption spectrum, wherein Fig. 5(a) shows the result of investigating existence of a bond such as Si-OH with respect to a sample processed with plasma processing time as a parameter under the condition that the wafer temperature is maintained constant at 350°C, and Fig. 5(b) shows the result of investigating existence of H₂O with respect to the same sample, which show the change of absorbance to the wave number (nm⁻¹) with the applied electric power as a parameter. Besides, the absorbance shown along the axis of ordinates is assigned arbitrarily with respect to respective lines corresponding to respective parameters.

As a result, it is noticed that a peak (swelling) showing H₂O and a bond such as Si-OH becomes smaller gradually as the plasma processing time gets longer.

According to above-described two different results of investigation, H₂O and the bond such as Si-OH becomes to disappear and the CVD SiO₂ film 11a becomes denser as the plasma processing time gets longer or as the wafer temperature gets higher. This fact is considered to be caused in such a manner that H₂O, Si-OH and the like are discharged outside the CVD SiO₂ film 11 by that active radical particles in the plasma collide with the surface of the CVD SiO₂ film 11 and the surface and the inside of the CVD SiO₂ film 11 are irradiated by ultraviolet light generated by discharge.

Besides, the results similar to the above were obtained when inert gas such as nitrogen gas and argon gas was used, too.

### (2) In the case of ammonia gas:

### (a) Type of investigation

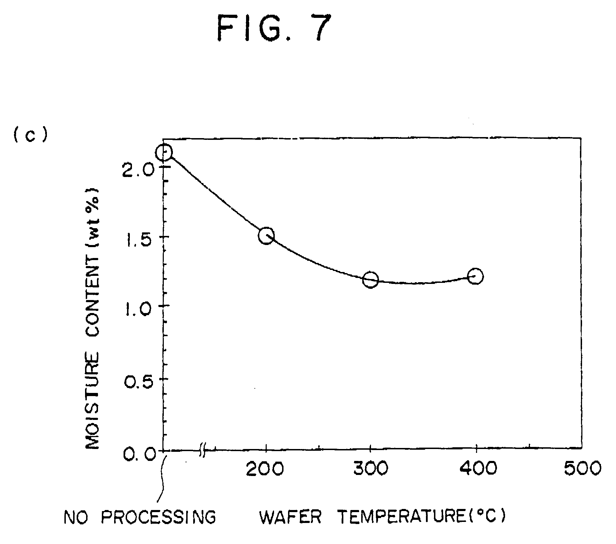

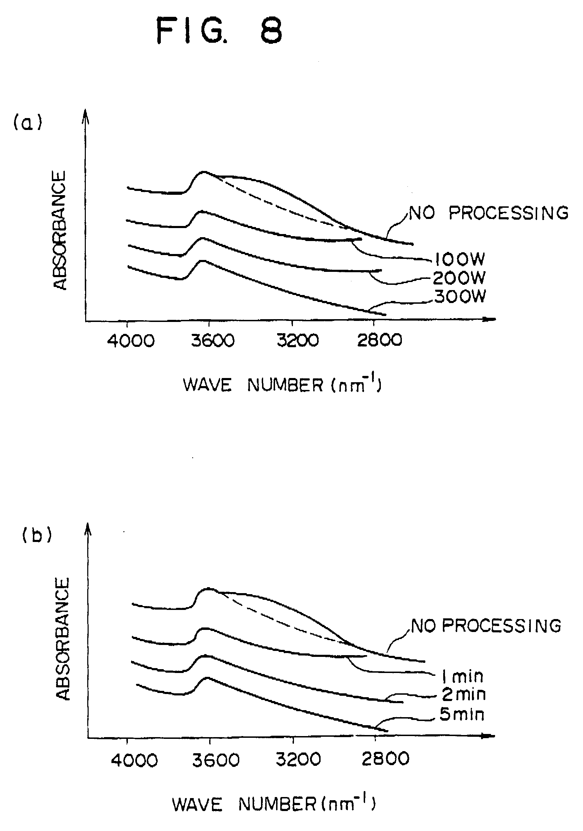

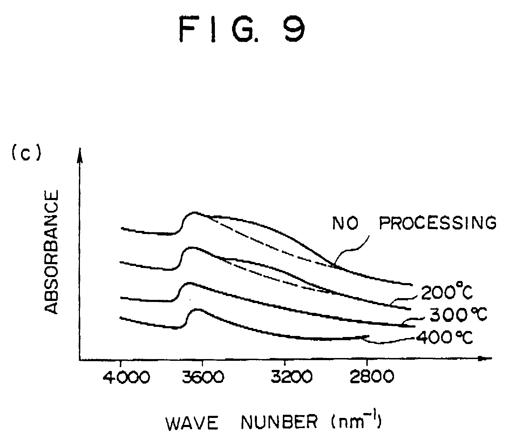

① Investigation of moisture content in a film by an electrochemical method (Figs. 6(a), (b) and Fig. 7(c)), and
② investigation of film composition by infrared absorption spectrum (Figs. 8(a), (b) and Figs. 9(c), (d))
were performed. Besides, similar investigation was made on a CVD SiO₂ film applied with no plasma processing and a thermal oxide film formed by thermal oxidization for the purpose of comparison.

### (b) Results of investigation

In the first place, the results of investigation on the moisture content in a film by an electrochemical method will be described.

Fig. 6(a) shows the change of the moisture content (wt %) in a film against an applied electric power under the conditions that the wafer temperature is at 400°C and the plasma processing time is maintained constant at one minute, and also shows that the moisture content is reduced about half as compared with a sample applied with no plasma processing.

Further, Fig. 6(b) shows the chance of the moisture content (wt %) against the plasma processing time under the conditions that the wafer temperature is at 400°C and the applied electric power is at 200W, and also shows that the moisture content is reduced about half as compared with a sample applied with no plasma processing.

Furthermore, Fig. 7(c) shows the change of the moisture content (wt %) in a film against the wafer temperature under the conditions that the applied electric power is at 200W and the plasma processing time is maintained constant at one minute, and also shows that the moisture content is reduced about half as compared with a sample applied with no plasma processing.

According to above-described results, it is considered that the CVD SiO₂ film 11a has become denser since the moisture content is reduced by performing plasma processing.

Next, the result of investigation on film composition by means of infrared absorption spectrum will be described. Fig. 8(a) shows the result of investigating the existence of H₂O with respect to the processed sample under the conditions that the plasma processing time is for one minute and the wafer temperature is maintained constant at 400°C, and shows the change of absorbance with respect to the wave number (nm⁻¹) with the applied electric power as a parameter. Besides, the absorbance shown along the axis of ordinates is assigned arbitrarily with respect to respective lines corresponding to respective parameters. According to the results, that which is applied with no plasma processing has a peak (swelling) being off from a dotted line corresponding to the case including no moisture, but, in those that have been applied with plasma processing, the peak showing the existence of H₂O disappear irrespective of the applied electric power.

Furthermore, Fig. 8(b) shows the result of investigating the existence of H₂O with respect to a sample processed with the plasma processing time as a parameter under the conditions that the applied electric power is at 200W and the wafer temperature is maintained constant at 400°C. As a result, in that which has been applied with plasma processing, the peak showing the existence of H₂O has disappeared irrespective of the plasma processing time.

Further. Fig 9(c) shows the result of investigating the existence of H₂O with respect to a sample processed with the wafer temperature as a parameter under the conditions that the applied electric power is at 200W and the plasma processing time is maintained constant at one minute. As a result, the peak showing the existence of H₂O becomes smaller gradually and disappears finally as the wafer temperature goes higher.

Besides, when the result shown in Fig. 9(c) of a case in which ammonia gas is used is compared with the result of the case of oxygen gas shown in Fig. 5(b), the peak showing the existence of H₂O becomes smaller gradually as the plasma processing time gets longer in that which is processed with oxygen was. Being different from that which is processed with ammonia gas, however, the peak was also slightly noticed in the case of the longest plasma processing time at 30 minutes in the range of the experiment. According to this result, it is recognized that plasma processing with ammonia has a larger effect than the plasma processing with oxygen.

According to the results of those two types of different investigation, H₂O disappears by applying plasma processing, and the CVD SiO₂ film 11a becomes denser. This is considered to be caused by a fact that H₂O and the like are discharged outside the CVD SiO₂ film 11 by that active radical particles in the plasma collide with the surface of the CVD SiO₂ film 11 or the surface and the inside of the CVD SiO₂ film 11 are irradiated with ultraviolet light generated by discharge.

As observed with above-described results of experiments, according to plasma processing of the present invention, moisture (H₂O) and the bond such as Si-OH is made to disappear so as to increase the density of the CVD SiO₂ film 11a formed at a low temperature. Thus, it is possible to remove a primary factor causing generation of moisture and the like out of the inside of the CVD SiO₂ film 11a and also to prevent immersion of moisture and the like from the outside of the CVD SiO₂ film 11a.

With this, it is possible to prevent lowering of dielectric strength of the CVD SiO₂ film itself, increase of leakage current between upper Aℓ interconnection formed on the CVD SiO₂ film later and lower Aℓ interconnection formed, and lowering of reliability due to corrosion of Aℓ interconnection and the like.

### BRIEF DESCRIPTION OF THE DRAWINGS

Fig. 1 shows sectional views for explaining a first variant of a comparative manufacturing method;
Fig. 2 shows sectional views for explaining a second variant of a comparative manufacturing method
Fig. 3 shows sectional views of a sample for experiment in a comparative manufacturing method
Fig. 4 shows explanatory diagrams for explaining results of investigation on an etching rate of a CVD SiO₂ film formed by a comparative manufacturing method
Fig. 5 shows explanatory diagrams for explaining results of investigation on infrared absorption spectrum of a CVD SiO₂ film formed by a comparative manufacturing method;
Fig. 6 shows comparison explanatory diagrams (1) showing results of investigation on moisture content of a CVD SiO₂ film formed by a manufacturing method of the present invention;
Fig. 7 shows comparison explanatory diagrams (2) showing results of investigation on moisture content of a CVD SiO₂ film formed by a manufacturing method of the present invention;
Fig. 8 shows comparison explanatory diagrams (1) showing results of investigation on infrared absorption spectrum of a CVD SiO₂ film formed by a manufacturing method of the present invention;
Fig. 9 shows a comparison explanatory diagram (2) showing results of investigation on infrared absorption spectrum of a CVD SiO₂ film formed by a manufacturing method of the present invention;
Fig. 10 shows schematic explanatory diagrams showing a plasma processing system used in the present invention; and
Fig. 11 shows schematic explanatory diagrams of a CVD film forming system used in the present invention.

### DETAILED DESCRIPTION OF THE INVENTION

Comparative manufacturing methods and embodiments of the present invention will be described hereinafter with reference to the drawings.

### ① The first variant of a comparative manufacturing method and the first embodiment of the invention

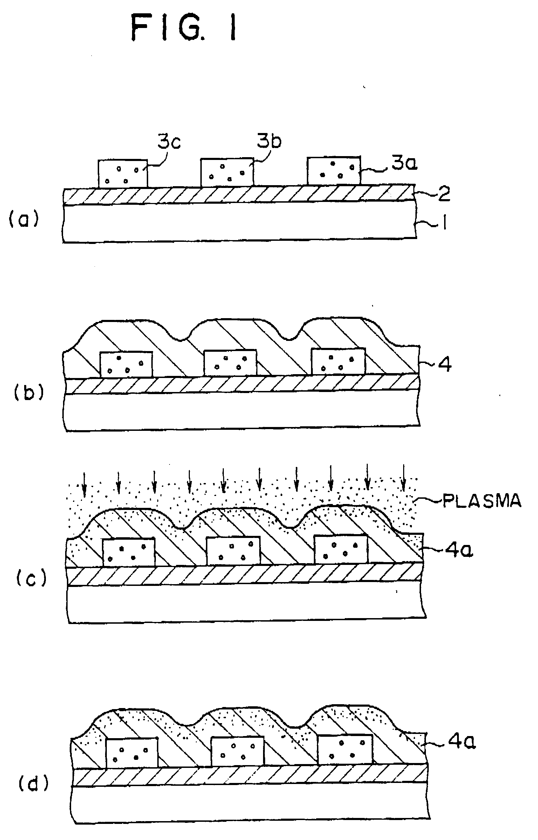

Figs. 1 (a) to (d) are sectional views for explaining a method for forming an interlevel insulating film. Further, Fig. 11 is a schematic diagram of a CVD system used for forming an interlevel insulating film, and Figs. 10(a) and (b) are structural diagrams of a plasma processing system used for plasma processing of an interlevel insulating film formed by the CVD system shown in Fig. 11.

First, such a CVD system and a plasma processing system will be described.

### (A) CVD system used

Fig. 11 shows a CVD system for forming a SiO₂ film by a thermal CVD method using mixed gas of TEOS/O₃.

In Fig. 11, a reference numeral 26 represents a chamber, 27 represents a reaction gas inlet port for introducing reaction gas into the chamber 26, 28 represents an outlet port for reducing pressure in the chamber 26 and/or exhausting processed gas and the like out of the chamber 26, 30 represents a wafer placing table on which a wafer 1 as a body to be formed is placed and containing inside a heater for heating the wafer 1, and 31 represents a gas shower for having the reaction gas pour on the wafer 1.

Further, 32a represents a gas piping for feeding the reaction was to the chamber 26, and gas pipings 32b, 32c, 32e and 32g for feeding ozone (O₃) gas, nitrogen gas containing a TEOS solution and others are connected thereto. 32b represents a gas piping for feeding oxygen (O₂) gas or ozone gas generated by an ozonizer 33, 32c represents a gas piping for feeding nitrogen (N₂) gas containing a TEOS solution, 32e represents a gas piping for feeding nitrogen gas containing a TMPO or TMOP (Tri Methyl Phosphate: PO (OCH₃)₃; hereinafter referred to as TMOP) solution, and 32g represents a gas piping for feeding nitrogen gas containing TEB (Tri Ethyl Borote) solution. Further, valves 35a to 35c, 35e and 35g for regulating conduction/suspension are provided on respective gas pipings 32b, 32c, 32e and 32g. Furthermore, 32d, 32f and 32h represent gas pipings for feeding nitrogen gas to the TEOS solution, the TMOP solution and the TEB solution, respectively, and valves 35d, 35f and 35h for regulating conduction/suspension are provided on respective gas pipings 32d, 32f and 32h.

Further, 33 represents an ozonizer connected to the gas piping 32b, 34a to 34c represents heaters for heating and heat insulating the TEOS solution, and TMOP solution and the TEB solution, respectively, and 36a to 36d represent mass flow controllers for regulating flow rate of oxygen gas and nitrogen gas as carrier gas.

Besides, the TMOP solution is used for forming a PSG (phosphorous glass) film, the TEB solution is used for forming a BSG (baron glass) film, and furthermore, both of these solutions are used for forming a BPSG (boronphosphorous glass) film.

### (B) Plasma processing system used

Further, Fig. 10(a) shows a plane parallel plate type plasma processing system. A reference numeral 12 in the figure represents a chamber, 13 represents a gas inlet port for introducing processing gas into the chamber 12, 14 represents an exhaust port for reducing pressure in the chamber 12 and/or exhausting processed gas and the like, 16 represents a wafer placing table containing inside a heater for heating the wafer 1, and 17 represents one electrode for converting the gas into plasma. Alternating voltage is applied between this electrode 17 and the wafer placing table 16 connected to ground by means of an RF power supply 18 connected to the electrode 17 so that the processing gas introduced into the chamber 12 is converted into plasma.

Furthermore, Fig. 10(b) shows another hot-wall type plasma processing system capable of batch processing. A reference numeral 19 in the figure represents a chamber composed of a quarts tube, 20 represents a gas inlet port for introducing processing gas into the chamber 19, 21 represents an exhaust port for reducing pressure in the chamber 19 and/or exhausting processed gas and the like, and 23 represents a pair of discharge electrodes for converting the processing gas into plasma. Alternating voltage is applied between one electrode and the other electrode connected to ground by means of an RF power supply 24 connected to one electrode so that the processing gas introduced into the chamber 19 is converted into plasma.

### (C) Method for forming interlevel insulating film with plasma processing using oxygen gas (first comparative variant) invention

In the next place, an interlevel insulating film which is formed on a semiconductor substrate using the CVD system shown in Fig. 11 and the plasma processing system shown in Fig. 10(a) will be described with reference to Figs. 1(a) to (d). Plasma processing using oxygen gas is performed therein.

First, as shown in Fig. 1(a), a SiO₂ film 2 is formed on a Si substrate (wafer: semiconductor substrate) 1 by the thermal oxidization, and Aℓ interconnections 3a to 3d are formed on the SiO₂ film 2 thereafter.

Then, after placing the wafer 1 on the wafer placing table 30 in the chamber 26 of the CVD system shown in Fig. 11, the wafer 1 is heated by the heater and maintained at a temperature of approximately 400°C, and valves 35a and 35b are opened so as to conduct oxygen gas into the ozonizer 33, thereby to introduce the oxygen gas into a gas piping 32 so as to obtain the ozone gas concentration in oxygen gas at approximately 1% while regulating a mass flow controller 36a. Further, valves 35c and 35d are opened at the same time, and nitrogen gas of a predetermined flow rate including the TEOS solution is introduced to the gas piping 32 while regulating a mass flow controller 36b. Furthermore, the mixed gas of TEOS/O₃ introduced into the gas piping 32 as described above passes through the gas inlet port 27 of the chamber 26 and is introduced into the chamber 26. As a result, reaction occurs on the wafer 1, and a CVD SiO₂ film 4 is started to be formed. This state is maintained for a predetermined period of time, and Aℓ interconnections 3a to 3c on the wafer 1 are covered so as to form the CVD SiO₂ film 4 having a film thickness of approximately 8,000Å (Fig. 1(b)).

Next, the wafer 1 is taken out of the chamber 26 of the CVD system, and placed on the wafer placing table 16 in the chamber 12 of the plane parallel plate type plasma processing system shown in Fig. 10(a) for the purpose of reforming the CVD SiO₂ film 4. Thereafter, the wafer temperature is maintained at approximately 350°C by the heater, and oxygen gas is introduced through a gas inlet port 13 while exhausting the inside of the chamber 12 through a gas exhaust port 14 and the inside of the chamber 12 is maintained at a predetermined pressure. Then, high frequency voltage of the frequency at 13.56 MHz is applied between the electrode 17 and the wafer placing table 16 by the RF power supply 18 so as to convert the oxygen gas into plasma. Then, the CVD SiO₂ film 4 is held for 60 minutes while keeping it exposed to oxygen plasma gas, thus completing reforming of the CVD SiO₂ film 4 (Figs. 1(c) and (d)).

According to above-described method for forming an interlevel insulating film, the CVD SiO₂ film 4 is formed at a low temperature. Thus, it is possible to prevent hillocks and the like of Aℓ interconnections 3a to 3c from being generated.

Further, since plasma processing is performed, much moisture (H₂O) and bonds such as Si-OH and Si-H are removed from the CVD SiO₂ film 4a containing them at time of formation due to formation at a low temperature as shown in Figs. 5(a) and (b), and the CVD SiO₂ film 4a is densified as shown in Figs. 4(a) and (b). Thus, it is possible to remove a primary factor causing moisture generation from the inside of the CVD SiO₂ film 4a and also to prevent immersion of moisture from the outside of the CVD SiO₂ film 4a.

With this, it is possible to prevent lowering of dielectric strength of the CVD SiO₂ film 4 itself, increase of the leakage current between upper Aℓ interconnection formed on the CVD SiO₂ film 4a later and lower Aℓ interconnections 3a to 3c, and lowering of reliability due to corrosion and the like of the Aℓ interconnections 3a to 3c.

Besides, a CVD SiO₂ film 4 formed under the conditions that the mixed gas of TEOS-O₃ is used at the temperature of 400°C is used in the first embodiment, but it may be formed within the range of 350°C to 450°C as the temperature condition. Further, a CVD SiO₂ film formed under the conditions that the reaction gas is a mixed gas of silane (SiH₄)/oxygen (O₂) and the temperature is from 350°C to 450°C may also be used.

Furthermore, oxygen gas is used as the gas to be converted into plasma, but it is also possible to use inert gas such as nitrogen gas and argon ga.

### (D) Method for forming an interlevel insulating film according to the present invention

Next, the first embodiment of the present invention for forming an interlevel insulating film on a semiconductor substrate using the CVD system shown in Fig. 11 and the plasma processing system shown in Fig. 10(a) will be described with reference to Figs. 1(a) to (d). What differs from the comparative variant in the first embodiment of the invention is that plasma processing using ammonia gas is performed.

First, as shown in Fig. 1(a), after forming a SiO₂ film 2 on a Si substrate (wafer: semiconductor substrate) 1 similarly to the first embodiment, Aℓ interconnections 3a to 3c are formed on the SiO₂ film 2. Thus, a body to be formed is constructed.

In succession, as shown in Fig. 1(b), a CVD SiO₂ film (insulating film) 4 having a film thickness of approximately 8,000Å is formed on the body to be formed using the CVD system shown in Fig. 11 similarly to the first embodiment.

Next, the wafer 1 is taken out of the chamber 26 of the CVD system, and placed on the wafer placing table 16 in the chamber 12 of the plane parallel plate type plasma processing system shown in Fig. 10(a) for the purpose of reforming the CVD SiO₂ film 4.

Thereafter, the wafer 1 is heated by the heater contained inside the wafer placing table 16 so as to maintain the wafer temperature at approximately 400°C, inside of the chamber 12 is exhausted through the exhaust port 14, and ammonia gas is introduced through the gas inlet port 13 when a predetermined pressure is reached so as to maintain the pressure inside the chamber 12 at approximately 1 Torr.

Then, high frequency electric power of approximately 200W having a frequency of 13.56 MHz is applied between the electrode 17 and the wafer placing table 16 by means of the RF power supply 18, thereby to convert ammonia gas into plasma. Then, when the CVD SiO₂ film 4 is held for one minute in this state as it is exposed to ammonia gas, reforming of the CVD SiO₂ film 4 is completed (Figs. 1(c) and (d)).

In the CVD SiO₂ film 4 thus formed, according to the results of performing:
① investigation of moisture content in a film by an electrochemical method (see Figs. 6(a), (b) and Fig. 9(c)), and
② investigation of film composition by infrared absorption spectrum (see Figs. 8(a), (b) and Fig. 9(c)),
the moisture content is reduced approximately half as compared with a case in which no processing is performed as shown in Figs. 6(a), (b) and Fig. 7(c), and peaks (swellings) showing existence of moisture (H₂O) disappear as shown in Figs 8(a), (b) and Fig. 9(c). Accordingly, it is considered that the CVD SiO₂ film 11a has become denser. When this CVD SiO₂ film 4 was left in the atmosphere as it is for one week_{,} but no change was shown in the moisture content in the CVD SiO₂ film 4. This fact shows that a primary factor causing generation of moisture has been removed from the inside of the CVD SiO₂ film 4a and immersion of new moisture from the outside of the CVD SiO₂ film 4 is prevented, and that the CVD SiO₂ film 11a has been made denser. This is considered to have occurred because of such a reason that H₂O and the like are discharged outside the CVD SiO₂ film 11 by that active radical particles in the plasma collide with the surface of the CVD SiO₂ film 11 and the surface and the inside of the CVD SiO₂ film 11 are irradiated with ultraviolet light generated by discharge.

Besides, when the result shown in Fig. 9(c) of a case when ammonia gas is used is compared with the result shown in Fig. 5(b) of a case when oxygen gas is used, the peak showing the existence of H₂O becomes smaller gradually as the plasma processing time gets longer in those that are processed with oxygen gas. However, being different from those that are processed with ammonia gas, the peak has been noticed slightly even at the longest plasma processing time for 30 minutes in the range of experiment. According to this result, it is recognized that ammonia plasma processing has bigger effects than oxygen plasma processing.

As described above, according to the method for forming an interlevel insulating film in the first embodiment of the present invention, the CVD SiO₂ film 4 is formed at a low temperature. Hence, it is possible to prevent hillocks and the like of Aℓ interconnections 3a to 3c from generating.

Further, plasma processing being performed, much moisture (H₂O) and bonds such as Si-OH and Si-H are removed from the CVD SiO₂ film 4a containing them at time of forming due to formation at a low temperature, and the CVD SiO₂ film 4a is densified. Thus, it is possible to remove a primary factor causing generation of moisture from the inside of the CVD SiO₂ film 4a, and also to prevent moisture and the like from immersing from the outside of the CVD SiO₂ film 4a.

With this, it is possible to prevent lowering of dielectric strength of the CVD SiO₂ film 4a itself, increase of leakage current between upper Aℓ interconnection formed on the CVD SiO₂ film 4a later and lower Aℓ interconnections 3a to 3c and lowering of reliability due to corrosion of Aℓ interconnections 3a to 3c and the like.

Besides, in this embodiment, the wafer temperature is set at 400°C in plasma processing, but it may be set within the range of 200°C to 400°C. Further, high frequency electric power for plasma conversion is set at 200W, but the order of 100 to 300W may be adopted.

### ② The second comparative variant and the second embodiment of a manufacturing method of the present invention

### (A) The second comparative variant

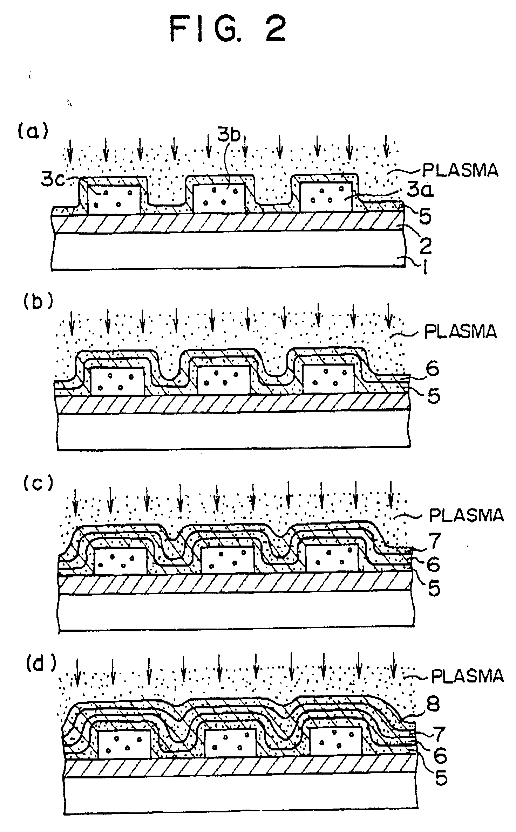

Figs. 2(a) to (d) are sectional views for explaining a method for forming an interlevel insulating film in the third embodiment of a manufacturing method of the present invention. Plasma processing using oxygen gas is performed.

What differs from the first comparative variant is that a predetermined film thickness of 8,000Å is formed finally by applying the film manufacturing method to every film thickness of 2,000Å instead of forming the predetermined film thickness of 8,000Å at a time.

First, as shown in Fig, 2(a), Aℓ interconnections 3a to 3c are formed after forming a SiO₂ film 2 on a Si substrate (wafer: semiconductor substrate) 1 by thermal oxidation. Then, a first CVD SiO₂ film 5 having a film thickness of approximately 2,000Å is formed similarly to the first comparative variant by mixed gas of TEOS/O₃ using the CVD system shown in Fig. 1. Then, the first CVD SiO₂ film 5 is exposed to oxygen gas converted into plasma for about 30 minutes under the condition that the wafer temperature is at approximately 400°C using the plasma processing system shown in Fig. 10(a). At this time, since the film thickness of the first CVD SiO₂ film 5 is sufficiently thin as shown in Figs. 4(a), (b) and Figs. 5(a), (b) (hereinafter referred to as Fig. 4(a) and others), the film quality is improved extending over the entire film thickness.

Next, a second CVD SiO₂ film 6 having film thickness of approximately 2,000Å is formed similarly to the process shown in Fig. 2(a), and plasma processing is applied by oxygen gas converted into plasma (Fig. 2(b)). At this time, since the film thickness of the second CVD SiO₂ film 6 is also sufficiently thin, the film quality is improved extending over the entire film thickness as shown in Fig. 4(a) and others.

Then, a third CVD SiO₂ film 7 having a film thickness of approximately 2,000Å is formed and applied with plasma processing similarly to the above (Fig. 2(c)).

Then, a fourth CVD SiO₂ film 8 is formed and applied with plasma processing (Fig. 2(d)). At this time, since respective film thicknesses of the third and the fourth CVD SiO₂ films 7 and 8 are also sufficiently thin, the film quality is improved extending over the entire film thickness as shown in Fig. 4(a) and others.

As described above, according to the second comparative variant, a predetermined film thickness of 8,000Å is formed finally by applying the interlevel insulation film manufacturing method present invention to every sufficiently thin film thickness of 2,000Å. Therefore, it is possible to further improve the film quality of the CVD SiO₂ films 5 to 8 as compared with the first comparative variant.

### (B) The second embodiment of the invention

Figs. 2(a) to (d) are sectional views for explaining a method for forming an interlevel insulating film in the second embodiment of a manufacturing method of the present invention. Plasma processing using ammonia gas is performed therein.

What differs from the first embodiment is that a predetermined film thickness of 8,000Å is formed finally by applying the manufacturing method of the present invention to every film thickness of 2,000Å instead of forming the predetermined film thickness of 8,000Å at a time.

First, as shown in Fig. 2(a), after forming a SiO₂ film 2 on a Si substrate (wafer: semiconductor substrate) 1 by thermal oxidation, Aℓ interconnections 3a to 3c are formed similarly to the first embodiment of the invention. Besides, a body to be formed is structured with the above.

Then, a first CVD SiO₂ film (insulating film) 5 having a film thickness of approximately 2,000Å is formed similarly to the first embodiment by mixed gas of TEOS/O₃ using the CVD system shown in Fig. 11.

Then, the first CVD SiO₂ film 5 is exposed to ammonia gag converted into plasma for about one minute under the condition that the wafer temperature is at approximately 400°C using the plasma processing system shown in Fig. 10(a). At this time, since the film thickness of the first CVD SiO₂ film 5 is sufficiently thin, the film quality is improved extending over the entire film thickness as shown in Figs. 6(a), (b), Fig. 7(c), Figs. 8(c), (b) and Fig. 9(c) (hereinafter referred to as Fig. 6(a) and others).

Next, a second CVD SiO₂ film (insulating film) 6 having a film thickness of approximately 2,000Å is formed similarly to the process shown in Fig. 2(a), and exposed to ammonia gas converted into plasma so as to be applied with plasma processing (Fig. 2(b)). At this time, as shown in Fig. 6(a) and others, the film quality is improved extending over the entire film thickness since the film thickness of the second CVD SiO₂ film 6 is also sufficiently thin.

Then, a third CVD SiO₂ film (insulating film) 7 having a film thickness of approximately 2,000Å is formed and applied with plasma processing (Fig. 2(c)) similarly to the above. In succession, a fourth CVD SiO₂ film (insulating film) 8 is formed and applied with plasma processing (Fig. 2(d)). At this time, as shown in Fig. 6(a) and others, the film quality is improved extending over the entire film thickness since the film thicknesses of both the third and the fourth CVD SiO₂ films 7 and 8 are sufficiently thin.

As described above, according to the second embodiment of the present invention, a predetermined film thickness of 8,000Å is formed finally by applying the manufacturing method of the present invention to every sufficiently thin film thickness of 2,000Å. Hence, the film quality of the CVD SiO₂ films 5 to 8 can be further improved as a whole as compared with the first embodiment.

## Claims

1. A low temperate method for manufacturing a semiconductor device comprising:
contacting an insulating film (4), which is a SiO₂ film or a SiO₂ film doped with impurities such as PSG film, a BSG film or a BPSG film and which is formed by low temperature chemical vapor deposition on a device substrate (1), with a plasma while heating said insulating film (4), thereby densifying said film (4), characterized in that the plasma consists of ammonia gas.

2. The low temperature method of manufacturing a semiconductor device according to claim 1, wherein said contacting is conducted with said film (4) at a temperature of 350 °C to 450 °C.

3. The low temperature method for manufacturing a semiconductor device according to claims 1 to 2, wherein said insulating film (4) is formed on said substrate (1) by repeating the manufacturing method two times or more.

## Patentansprüche

1. Niedrigtemperaturverfahren zur Herstellung eines Halbleiterbauteils, umfassend:
Das In-Kontakt-Bringen eines isolierenden Films (4), bei dem es sich um einen SiO₂-Film oder einen mit Verunreinigungen dotierten SiO₂-Film wie einen PSG-Film, einen BSG-Film oder einen BPSG-Film handelt und der mittels chemischer Dampfabscheidung bei niedriger Temperatur mit einem Plasma unter Erwärmen des isolierenden Films (4) auf einem Bauteilsubstrat (1) gebildet wird, wodurch der Film (4) verdichtet wird, dadurch gekennzeichnet, dass das Plasma aus Ammoniakgas besteht.

2. Verfahren zur Herstellung eines Halbleiterbauteils gemäß Anspruch 1, bei dem das In-Kontakt-Bringen mit dem Film (4) bei einer Temperatur von 350°C bis 450°C durchgeführt wird.

3. Verfahren zur Herstellung eines Halbleiterbauteils gemäß den Ansprüchen 1 und 2 wobei der isolierende Film (4) durch zweimalige oder öftere Wiederholung des Herstellungsverfahrens auf dem Substrat (1) ausgebildet wird.

## Revendications

1. Procédé pour fabriquer à basse température un dispositif semiconducteur, comprenant:
la mise en contact d'un film isolant (4), qui est un film de SiO₂ ou un film de SiO₂ dopé avec des impuretés telles qu'un film de PSG, un film de BSG ou un film de BPSG et qui est formé par dépôt en phase vapeur par voie chimique à basse température sur un substrat (1) de dispositif, avec un plasma tout en chauffant ledit film isolant (4), en densifiant de ce fait ledit film (4), caractérisé en ce que le plasma est constitué de gaz ammoniac.

2. Procédé de fabrication d'un dispositif semiconducteur selon la revendication 1, dans lequel ladite mise en contact est effectuée avec ledit film (4) à une température de 350°C à 450°C.

3. Procédé, de fabrication d'un dispositif semiconducteur selon les revendications 1 et 2, dans lequel ledit film isolant (4) est formé sur ledit substrat (1) en répétant deux fois ou davantage le procédé de fabrication.
